# EUROPÄISCHE PATENTSCHRIFT

(11) **EP 2 172 757 B1**
(45) Veröffentlichungstag und Bekanntmachung des Hinweises auf die Patenterteilung: **17.08.2011**
(21) Anmeldenummer: 08017379.2
(22) Anmeldetag: 02.10.2008
(51) Int. Cl.: G01L 1/02, G01L 5/00, H01L 21/00, H01L 31/18, H01L 41/113

(54) **Verfahren und Vorrichtung zur Erfassung physikalischer Parameter**
Method and device for recording physical parameters
Procédé et dispositif destinés à l'enregistrement de paramètres physiques

(43) Veröffentlichungstag der Anmeldung: 07.04.2010
(73) Patentinhaber: RENA GmbH, 78148 Gütenbach (DE)
(72) Erfinder: Dechant-Wagner, Roland, 78056 Villingen-Schwenningen (DE); Schweckendiek, Jürgen, 10967 Berlin (DE); Münch, Michael, 96450 Coburg (DE); Singer, Ferdinand, 96450 Coburg (DE); Stich, Sebastian, 92318 Neumarkt i. d. Oberpfalz (DE); Beringer, Klaus, 91161 Hilpolostein (DE); Pabst, Christoph, 49326 Melle (DE); Krempel, Sandro, 96515 Judenbach (DE); Lindner, Gerhard, 96450 Coburg (DE)
(74) Vertreter: Stürken, Joachim

(56) Entgegenhaltungen:
- DE-A1- 3 126 340
- US-A- 5 444 637
- US-A1- 2002 187 025
- US-A1- 2004 098 216
- US-B1- 6 244 121

## Beschreibung

Die vorliegende Erfindung betrifft Verfahren und Vorrichtungen zur Erfassung physikalischer Parameter wie insbesondere zur Erfassung mechanischer Kräfte oder Belastungen, die im Rahmen üblicher Behandlungen wie beispielsweise bei der Fertigung von Solarzellen auf dieselben einwirken.

Bei der Bearbeitung von flachen, scheibenartigen und bruchempfindlichen Gegenständen (im Folgenden auch kurz "Substrate" oder "Gegenstände" genannt), wie beispielsweise bei der Herstellung von Solarzellen und der vorbereitenden Herstellung von Siliziumscheiben für Solarzellen, ist die Verminderung von Bruch ein wesentliches Element zur Verbesserung der Produktivität. Dies gilt schon bei einer Standarddicke der Siliziumwafer von 300 µm und selbst bei der Verwendung von monokristallinem Silizium. Aufgrund der Tendenz zu immer geringeren Substratdicken, welche beispielsweise bei der Solarzellenfertigung 150 µm und weniger betragen können, wird dieses Problem verstärkt beobachtet. Zudem erweisen sich derzeit in gesteigertem Maße eingesetzte Materialien wie z.B. poly- oder multikristallines Silizium als noch weitaus bruchanfälliger als monokristallines Silizium. Damit werden im Rahmen dieser Bearbeitungen oder Behandlungen neue Anforderungen hinsichtlich der Verminderung von Bruch gestellt.

Auch außerhalb eines regulären Betriebes kann Bruch auftreten, so z.B. während des Einfahrens einer neu aufgebauten oder modifizierten Anlage, aber auch als Folge einer verminderten Maschinenverfügbarkeit, die sich aus dem Aufwand für Reinigung der Anlage und Bruchentfernung ergibt. Im Verlauf einer Fertigungslinie kann Bruch direkte Verluste in der Größenordnung von 4-8% des verwendeten Materials ausmachen. Aufgrund der hohen Effizienz, die für die industrielle Massenproduktion von z.B. Solarzellen, aber auch von anderen Halbleiterprodukten erforderlich ist, finden in modernen Fertigungslinien so genannte Durchlaufanlagen zunehmende Verwendung. Mit solchen Fertigungsanlagen sollen die besonders kritischen Umordnungsvorgänge (den Transfer von einem Träger in einen anderen) vermieden werden, indem die flachen Substrate (Wafer) mit besonders ruhig und erschütterungsfrei arbeitenden Rollentransportsystemen von einer Behandlungsstation zur nächsten geführt werden. Dennoch bergen auch solche Rollentransportsysteme noch Bruchrisiken. Das gilt auch für solche Systeme, bei denen nur geringe Kräfte auf die Einzelscheibe ausgeübt werden und Mechanismen zur automatischen Zentrierung der Scheiben in den Anlagenspuren vorgesehen sind. Um die Bruchgefahr der empfindlichen Substrate zu verringern, wurden spezielle Transportsysteme entwickelt, wie sie z.B. die WO 03/086913 oder die WO 03/086914 offenbaren.

Neben einem ungenügenden Transportsystem kann dabei immer auch eine Fehljustierung der Anlage eine mögliche Ursache für Bruch darstellen. Oft ist es schwierig zu unterscheiden, ob eine Vorschädigung des Substratmaterials Ursache für erhöhte Bruchraten sind, oder ob es sich um eine Fehljustierung der Anlage handelt.

Anlagen aktueller Bauart bieten, wenn überhaupt, nur eingeschränkte Möglichkeiten zur Messung von insbesondere mechanischen Parametern wie Druckkräften, Impulskräften, Beschleunigungen oder Biegemomenten, die während der Behandlung auf die Substrate wirken. Insbesondere existieren keine Lösungen, die diese Parameter außerhalb von ganz bestimmten, im Voraus konstruktiv festgelegten Orten messen, an denen die entsprechenden Sensoren eingebaut sind. Daher ist selbst durch den Einsatz von Messtechniken, die in Fertigungs- oder Handhabungsanlagen integriert sind, nur eine Aufnahme diskreter, jedoch nicht kontinuierlicher Messwerte möglich. Da sich die Orte kritischer Belastung häufig nur schwer vorhersagen lassen, resultiert daraus entweder eine hohe Anzahl erforderlicher Sensoren, oder die Notwendigkeit eines häufigen Umsetzens der Sensoren im Falle einer geringeren Anzahl derselben. Damit verbunden sind entsprechende Zeit- und/oder Kostenaufwendungen, die insbesondere dadurch verstärkt werden, dass Stillstandzeiten der Anlage zu entsprechenden Fertigungsausfällen und somit zu einer weiteren Reduzierung der Produktivität führen.

Die bisherige Vorgehensweise einer Anpassung der Anlage erfolgt im Wesentlichen durch Probieren, wobei eine größere Datenbasis (aufgrund einer höheren Anzahl von Sensoren) ein zielgerichteteres Vorgehen erlaubt. Jedoch spielt auch die Erfahrung des die Justierung vornehmenden Anwenders eine große Rolle. Auch hier ist mit entsprechenden Stillstandzeiten und/oder mit zumindest vorübergehend erhöhten Bruchraten des durchlaufenden Materials zu rechnen.

Schließlich kann es durchaus vorkommen, dass Brüche erst durch das sequentielle Überbelasten während des Durchlaufens zustande kommen. Eine Justierung an einer ersten Stelle erhöhter Belastung reduziert zwar das Risiko, lässt aber gegebenenfalls die Möglichkeit einer weiteren Reduzierung außer acht, wie sie durch das Erkennen einer weiteren Stelle erhöhter Belastung möglich wäre. Verschärft wird diese Problematik, wenn mehrere Belastungen parallel auftreten, beispielsweise Druckkräfte und Biegemomente. Eine Identifikation dieser Belastungen "von außen" ist in solchen Fällen kaum möglich, so dass im Normalfall aus Unkenntnis der Belastungen auch keine entsprechenden Justiermöglichkeiten an den Anlagen vorgesehen werden.

Umgekehrt könnten Durchlaufanlagen bei genauer Kenntnis der auf die Substrate wirkenden Belastungen auch insofern aufgabengerechter konstruiert werden, als das auf kostenintensive, aber unnötige Maßnahmen zum Schutz der Substrate, z.B. besonders niedrige Transportgeschwindigkeiten oder Beschleunigungen sowie aufwändige Handhabungsvorrichtungen, verzichtet werden kann.

Da neben den bereits erwähnten zu hohen Belastungen auch Materialfehler für Bruch der Substrate verantwortlich sein können, sind solche Fehler durch entsprechende Untersuchungen nachzuweisen oder zu widerlegen. Auch dadurch entsteht ein entsprechender Zeit- und Kostennachteil, da derartige Materialuntersuchungen immer mit einem Zeitverlust einhergehen, woraus Stillstandzeiten der Anlage resultieren.

Die erfolgreiche Verminderung oder Verhinderung von Bruch im Verlauf der Fertigung hat einen besonders hohen Wert für die Verbesserung der Produktivität. Ein wesentlicher Anteil des Bruchs ist auf die mechanische Handhabung der Wafer zurückzuführen. Selbst bei einer gut eingestellten Anlage ist der mechanische Transport oder der Transfer von einer Station zu einer anderen ein wesentlicher Faktor, der zur Entstehung von Bruch führen kann.

Aufgabe der Erfindung ist es daher, in einfacher und kostengünstiger sowie schneller Weise physikalische Parameter wie insbesondere mechanische Kräfte und Belastungen, die im Rahmen einer üblichen Behandlung auf zu behandelnde flache Gegenstände wirken, zu erfassen. Damit kann in einer Situation, bei der vermehrt Bruch auftritt, die jeweilige Ursache zuverlässig erkannt und für Abhilfe gesorgt werden. Die Erfassung der hierzu notwendigen Parameter soll unter weitgehender Vermeidung von Stillstandzeiten der betreffenden Anlage geschehen. Zur Kostenminimierung soll hierzu einerseits nur eine minimale Anzahl von Sensoren erforderlich sein, andererseits sollen jedoch Daten von möglichst allen Orten gewonnen werden können, die von einem Substrat im Rahmen einer üblichen Behandlung durchlaufen werden. Zudem soll das Verfahren unabhängig von der Erfahrung eines Anwenders eingesetzt werden können.

Die Aufgabe wird durch Bereitstellung des in Anspruch 1 vorgeschlagenen Verfahrens sowie der in Anspruch 4 vorgeschlagenen Vorrichtung gelöst. Jeweils bevorzugte Ausführungsformen sind in den abhängigen Ansprüchen sowie in der nachfolgenden detaillierten Beschreibung und in den Figuren dargelegt. US 2004 098216 A offenbart ein Verfahren und eine Vorrichtung gemäß dem Oberbegriff von anspruch 1 bzw. 4.

Die Erfindung betrifft ein Verfahren zur Erfassung von physikalischen Parametern wie insbesondere von mechanischen Kräften und Belastungen, die im Rahmen einer üblichen Behandlung flacher, scheibenartiger und bruchempfindlicher Gegenstände auf dieselben einwirken. Derartige Gegenstände sind beispielsweise Siliziumscheiben, können jedoch auch Glasscheiben oder Keramikscheiben sein, die als Substrate für weitergehende Prozesse dienen.

Mit "üblicher Behandlung" sind alle Behandlungen gemeint, die im Stand der Technik auf flache, scheibenartige und bruchempfindliche Gegenstände angewendet werden. Die "Behandlung" erfolgt dabei definitionsgemäß in einer "Anlage". Die Behandlung kann dabei schrittweise erfolgen, also derart, dass die Gegenstände zu einer Anlage hin transportiert, dort einer Behandlung unterzogen, und dann von der Anlage weg und ggf. zu einer weiteren Anlage hin transportiert werden. Während der jeweiligen Behandlung stehen die Gegenstände im Wesentlichen still. Bevorzugt kann die Behandlung jedoch im Durchlauf erfolgen, d.h. die Gegenstände werden im Wesentlichen ununterbrochen transportiert. Durchlaufanlagen weisen insbesondere den Vorteil einer weitgehenden Vermeidung von Umladevorgängen auf, wodurch sowohl die Gefahr von Beschädigungen der Gegenstände vermindert als auch Zeit eingespart wird. Das erfindungsgemäße Verfahren sieht vor, dass die Behandlung auf einen Probekörper angewendet wird, der im Wesentlichen die geometrischen und/oder mechanischen Eigenschaften der Gegenstände aufweist. Der Begriff "Probekörper" definiert demnach einen Körper, der sich in einer Anlage, die zur Behandlung der flachen Gegenstände geeignet ist, im Wesentlichen ebenso handhabbar ist wie die betreffenden Gegenstände selber, jedoch bevorzugt eine derart verminderte Bruchgefahr aufweist, dass auch im Falle unüblicher (extremer) Belastungen keine Zerstörung des Probekörpers erfolgt. Aufgrund der ähnlichen Handhabbarkeit erfährt der Probekörper ähnliche, insbesondere mechanische Kräfte und Belastungen, denen auch die flachen Gegenstände während der Behandlung ausgesetzt sind. Ferner betrifft dieses Verhalten aber auch die Reaktionskräfte, die von dem Probekörper auf die Anlage wirken. Mit anderen Worten entspricht das Verhalten des Probekörpers im Rahmen seiner "Behandlung" in der Anlage im Wesentlichen demjenigen der flachen und bruchempfindlichen Gegenstände, für deren Behandlung die Anlage vorgesehen ist.

Wenn vorliegend von einer "Behandlung" des Probekörpers gesprochen wird, so ist damit lediglich gemeint, dass der Probekörper wie ein üblicherweise zu behandelnder flacher Gegenstand in die Anlage eingebracht, dort den typischen (insbesondere mechanischen) Belastungen ausgesetzt und anschließend wieder aus der Anlage entfernt wird, wobei es ausdrücklich nicht das Ziel der "Behandlung" ist, die Beschaffenheit oder Eigenschaften des Probekörpers zu verändern. Sofern auf bestimmte, die zu erfassenden Parameter nicht wesentlich beeinflussende Schritte wie z.B. ein Spül- oder Trocknungsschritt verzichtet werden kann, ist es bevorzugt, diese Schritte auch auszulassen bzw. entsprechende Medien, Temperaturerhöhungen usw. wegzulassen. Zum einen wird auf diese Weise unnötiges Vergeuden von Material verhindert, und zum anderen kann der Probekörper u.U. durch bestimmte

Behandlungsschritte wie z.B. ein Tempern Schaden nehmen, was selbstverständlich vermieden werden sollte.

Der erfindungsgemäße Probekörper umfasst mindestens einen Sensor zur Erfassung mindestens eines während der Behandlung auf den Probekörper einwirkenden physikalischen Parameters wie insbesondere einer auf ihn einwirkenden Kraft. Es kann auch vorgesehen sein, dass der mindestens eine Sensor mehrere unterschiedliche Parameter wie z.B. Kräfte und Momente erfassen kann. Im Hinblick auf den Sensor kann dies sowohl bauartbedingt als auch definitionsgemäß möglich sein. "Bauartbedingt" bedeutet, dass der Sensor aufgrund seiner Bauweise grundsätzlich immer mehrere Parameter erfassen kann. "Definitionsgemäß" bedeutet, dass der Sensor tatsächlich aus mehreren Sensorelementen besteht, die zu einer Einheit zusammengefasst sind, beispielsweise dadurch, dass sie in einem gemeinsamen Gehäuse untergebracht wurden. Auch in diesem Fall kann von einem "Sensor" gesprochen werden, sofern er als eine bauliche Einheit angesehen werden kann.

Bevorzugt sind die mit dem mindestens einen Sensor zu erfassenden physikalischen Parameter mechanischer Art, und aus der Gruppe bestehend aus Zugkräften, Druckkräften, Scherkräften, Drücken, Biegemomenten, Torsionsmomenten, Beschleunigungen, und Kombinationen davon ausgewählt. Definitionsgemäß zählen auch Rotationskräfte zu den Beschleunigungen ("Winkelbeschleunigungen"). Besonders bevorzugt ist vorgesehen, dass der mindestens eine Sensor mehrere der genannten Parameter erfassen kann, wobei es am meisten bevorzugt ist, dass diese Parameter Kräfte und Biegemomente sind.

Alternativ oder zusätzlich kann der mit dem mindestens einen Sensor erfassbare Parameter auch ein Temperaturwert, eine elektrische oder magnetische Feldstärke, oder ein anderer physikalischer Parameter sein.

Nach einer bevorzugten Ausführungsform ist vorgesehen, dass der mindestens eine Sensor bevorzugt aus der Gruppe bestehend aus Kraftsensoren, Drucksensoren, Momentensensoren, und Beschleunigungssensoren ausgewählt ist. Zu letzteren zählen definitionsgemäß auch Fliehkraftsensoren, mit denen Winkelbeschleunigungen erfasst werden können.

Damit die Handhabbarkeit des Probekörpers während der "Behandlung" und damit während des Durchlaufens der Anlage hinsichtlich der Empfindlichkeit gegenüber auftretenden Kräften weitgehend demjenigen eines zu behandelnden flachen Gegenstandes entspricht, weist der Probekörper im Wesentlichen die geometrischen und/oder mechanischen Eigenschaften der Gegenstände auf. Dabei ist es bevorzugt, dass die geometrischen Eigenschaften des Probekörpers die Dicke, Breite, Länge, und/oder die Kontur desselben betreffen, und dass die mechanischen Eigenschaften des Probekörpers die Elastizität, die Biegesteifigkeit, die Torsionssteifigkeit, und/oder die Masse desselben betreffen. Weitere Eigenschaften können beispielsweise der Kompressionsmodul oder der Schubmodul sein. Auf diese Weise verhält sich der Probekörper beim Durchlauf der Anlage im Wesentlichen wie ein zu behandelnder Gegenstand, was insofern bevorzugt ist, als dass die einwirkenden Kräfte und/oder Verformungen hinsichtlich des eigentlichen Behandlungsgegenstandes möglichst realistisch erfasst werden können. In den meisten Fällen sollten Überbelastungen des Probekörpers jedoch nicht zu Beschädigungen oder Zerstörung desselben führen, weshalb insbesondere die Bruchfestigkeit des Probekörpers entsprechend hoch gewählt werden sollte, damit der Probekörper mehrmals verwendet werden kann. Erfindungsgemäß wird jedoch nicht ausgeschlossen, dass die Bruchfestigkeit des Probekörpers derjenigen des zu behandelnden Gegenstandes entspricht oder sogar geringer ist, weshalb der Probekörper alternativ auch als Einmalartikel ausgestaltet sein kann.

Das erfindungsgemäße Verfahren kann bevorzugt so durchgeführt werden, dass zunächst so genannte Normwerte gewonnen werden. Diese Normwerte dienen dem späteren Vergleich mit Parametern, die ebenfalls mit dem erfindungsgemäßen Probekörper erfasst werden. Solche Normwerte können derart gewonnen werden, dass eine zufriedenstellend arbeitende Anlage mindestens einfach, bevorzugt jedoch mehrfach, von einem Probekörper durchlaufen wird und dabei die entsprechenden Parameter erfasst werden. Sofern mehrere Datensätze vorhanden sind, können z.B. statistische Daten wie ein Durchschnittswert und die Standardabweichung jedes Parameters an jeder beliebigen Stelle der Anlage errechnet werden. Wenn zu einem späteren Zeitpunkt Beschädigungen an flachen Gegenständen während deren Behandlung in der Anlage auftreten, kann die Anlage mit Hilfe des Probekörpers erneut vermessen werden. Durch einen Vergleich der neu erfassten Daten mit den Normwerten, die in diesem Falle Sollwerte darstellen, kann ermittelt werden, an welcher Stelle der Behandlung welcher Parameter von dem entsprechenden Normwert abweicht, so dass die Anlage an dieser Stelle neu eingestellt werden kann, um im weiteren Verlauf der kontinuierlichen Behandlung den Ausschluss weiterer Beschädigungen sicherzustellen.

Das erfindungsgemäße Verfahren kann auch vorteilhaft zum präzisen Einfahren einer neu installierten oder modifizierten Anlage eingesetzt werden, indem beispielsweise nach einer Grobjustierung Parameter wie insbesondere Kräfte beim Durchlaufen der Anlage mit dem erfindungsgemäßen Probekörper erfasst werden. Diese werden dann mit typischen Werten oder Normwerten verglichen, die beispielsweise aus der Kenntnis der mechanischen (und/oder thermischen, magnetischen, etc.) Belastbarkeit der zu behandelnden flachen Gegenstände stammen bzw. in Form gespeicherter Daten abgerufen werden können. Diese typischen Werte oder Normwerte können auf Erfahrungswerten und/oder Berechnungen basieren. Sie können jedoch auch aus Messungen stammen, die mit dem Probekörper auf anderen Anlagen durchgeführt wurden. Überall dort, wo die erfassten Parameter die typischen, d.h. erlaubten Werte übersteigen, sollte eine Nachjustierung erfolgen. Auf diese Weise ist ein äußerst effektives und somit zeit- und kostensparendes Einfahren der Anlagen gewährleistet.

Das Verfahren bietet darüber hinaus eine besonders sichere und schnelle Möglichkeit, den Grund für plötzlich auftretende Beschädigungen der zu behandelnden Gegenstände während einer Behandlung zu ermitteln. Hierzu kann beispielsweise wie folgt vorgegangen werden.

Zunächst werden die gewünschten physikalischen Parameter, besonders bevorzugt mechanische Belastungen wie Kräfte, Momente und Beschleunigungen, mit Hilfe des erfindungsgemäßen Probekörpers erfasst. Anschließend werden die erfassten Parameter mit zuvor erfassten, berechneten oder auf Erfahrungswerten basierenden Normwerten verglichen, wobei es besonders bevorzugt ist, dass die Normwerte auf einer Mehrzahl von Messungen beruhen, die mit dem Probekörper zu einem früheren Zeitpunkt an der betreffenden Anlage erfasst und ggf. statistisch ausgewertet wurden. Sodann wird entschieden, ob gegebenenfalls ermittelte Abweichungen als Verursacher beobachteter Beschädigungen in Betracht kommen. Für den Fall, dass die Entscheidung positiv ausfällt, ist die Anlage an den entsprechenden Stellen neu einzustellen. Für den Fall, dass die Entscheidung negativ ausfällt, ist es sehr wahrscheinlich, dass Materialfehler der Gegenstände die Ursache für die Beschädigungen sind, so dass entsprechend zielgerichtete Untersuchungen am Material der Gegenstände erfolgen sollten und eine unnötige Neueinstellung der Anlage unterbleiben kann.

Nach einer ersten Ausführungsform des erfindungsgemäßen Verfahrens ist vorgesehen, dass der bzw. die vom mindestens einen Sensor erfassten Parameter auf dem Probekörper gespeichert und von diesem nach Abschluss der Erfassung ausgelesen werden können. Nach einer anderen Ausführungsform ist es vorgesehen, dass die erfassten Parameter beispielsweise mittels einer im Probekörper angeordneten oder diesem zugeordneten Sendereinheit an eine Empfangs- und/oder Auswerteeinrichtung weitergeleitet werden, so dass eine Auswertung der erfassten Parameter zumindest in Quasi-Echtzeit möglich ist. Ein derartiges Vorgehen kann insbesondere dann vorteilhaft sein, wenn die Wegstrecke der betreffenden Anlage lang und/oder die Transportgeschwindigkeit des Probekörpers gering ist, da so ggf. die Wegstrecke nur teilweise, nämlich bis zum Auftreten eines ersten Fehlers, abgefahren werden muss und die Erfassung der Parameter dann abgebrochen werden kann, um die Anlage an der entsprechenden Stelle neu einzustellen.

Besonders bevorzugt kommt das erfindungsgemäße Verfahren bei der Fertigung oder Herstellung von Solarzellen oder Solarwafern zum Einsatz. Dabei ist es unerheblich, ob monokristallines, poly- oder multikristallines Silizium zum Einsatz kommt, oder ob es sich um Dünnschicht-Solarzellen mit z.B. Glassubstrat handelt.

Darüber hinaus kann das erfindungsgemäße Verfahren vorteilhaft in der Entwicklung von Transport- oder Handhabungssystemen zum Einsatz kommen, weil mit Hilfe des Probekörpers die mechanische Wirkung konkurrierender Transport- oder Handhabungslösungen auf die zu bearbeitenden flachen Gegenstände ermittelt werden kann.

Die Erfindung betrifft ferner eine Vorrichtung zur Erfassung von physikalischen Parametern wie insbesondere von mechanischen Kräften und Belastungen, die im Rahmen einer üblichen Behandlung flacher, scheibenartiger und bruchempfindlicher Gegenstände auf dieselben einwirken. Hinsichtlich der Bedeutung der Begriffe "Parameter", "übliche Behandlung" und "flache, scheibenartige und bruchempfindliche Gegenstände" wird auf die obigen Erläuterungen verwiesen. Gleiches gilt für die im Folgenden verwendeten Begriffe der "Anlage" und des "Substrats".

Erfindungsgemäß umfasst die Vorrichtung einen Probekörper, der im Wesentlichen die geometrischen und/oder mechanischen Eigenschaften der Gegenstände aufweist, und der nach einer ersten Ausführungsform als mindestens ein Sensor zur Erfassung mindestens eines physikalischen Parameters ausgebildet ist, welcher während der Behandlung auf den Probekörper einwirkt, wie insbesondere mechanische Belastungen. In dieser Ausführungsform sind demnach Probekörper und Sensor im Wesentlichen identisch, wobei erfindungsgemäß auch mehrere Sensoren gemeinsam den Probekörper bilden können.

Nach einer weiteren Ausführungsform umfasst der Probekörper den mindestens einen Sensor. Der mindestens eine Sensor ist nach dieser bevorzugten Ausführungsform auf oder in einem Basiskörper als Bestandteil des Probekörpers angeordnet. Eine Anordnung auf dem Basiskörper entspricht demnach einer aufgelagerten Anordnung, wohingegen eine Anordnung in dem Basiskörper einer voll- oder teilintegrierten oder sandwichartigen Anordnung entspricht.

Der erfindungsgemäße Basiskörper ist für die geometrischen und/oder mechanischen Eigenschaften des Probekörpers maßgeblich, da der erfindungsgemäße mindestens eine Sensor den Probekörper bevorzugt nur gering in seinen geometrischen und/oder mechanischen Eigenschaften beeinflusst. Der Basiskörper kann als Voll- oder Hohlkörper ausgestaltet sein. Es ist bevorzugt, dass der Basiskörper eingebettete Komponenten wie z.B. eine eingebaute Elektronik chemikalienfest umschließen kann, so dass die Erfassung von Messdaten auch unter Einwirkung von aggressiven Medien möglich ist. Hierzu kann der Basiskörper mindestens einseitig und bevorzugt allseitig von einer entsprechend resistenten Schicht überzogen sein. Alternativ kann die Elektronik, sofern es das Einsatzgebiet erlaubt, auch offen liegen. Als Material für den Basiskörper kommen bevorzugt Metalle oder metallische Werkstoffe zum Einsatz, was jedoch keinen Ausschluss anderer Materialien darstellen soll. Alternativ kann der Basiskörper daher insbesondere auch aus Kunststoffen, Leiterplattenwerkstoffen, oder aus epoxydharzartigen Werkstoffen bestehen.

Ebenfalls bevorzugt ist, dass der Basis- und somit auch der gesamte Probekörper in gewissem Umfang biegbar sind.

Bevorzugt sind die zu erfassenden physikalischen Parameter mechanischer Art und ausgewählt aus der Gruppe bestehend aus Zugkräften, Druckkräften, Scherkräften, Drücken, Biegemomenten, Torsionsmomenten, Beschleunigungen, und Kombinationen davon, wobei die Beschleunigungen auch Rotationsbeschleunigungen umfassen.

Der im Rahmen der erfindungsgemäßen Vorrichtung vorgesehene mindestens eine Sensor ist bevorzugt aus der Gruppe bestehend aus Kraftsensoren, Drucksensoren, Momentensensoren, und Beschleunigungssensoren ausgewählt. Letztere umfassen dabei auch solche Sensoren, die zur Erfassung von Winkelbeschleunigungen nutzbar sind. Zum Einsatz gelangen dabei alle aus dem Stand der Technik bekannten Sensoren für mechanische Belastungen, wobei insbesondere Sensoren auf der Basis von piezoelektrischen Kunststofffolien bevorzugt sind. Alternativ können auch piezoelektrische Keramiken oder mit solchen beschichtete Folien Verwendung finden.

Alternativ oder zusätzlich kann es vorgesehen sein, dass der mindestens eine Sensor zur Messung von Temperaturen, elektrischen Feldern, magnetischen Feldern oder anderen physikalischen Messgrößen geeignet ist.

Nach einer bevorzugten Ausführungsform betreffen die geometrischen Eigenschaften des Probekörpers die Dicke, Breite, Länge, und/oder die Kontur desselben. Nach einer weiteren Ausführungsform betreffen die mechanischen Eigenschaften des Probekörpers die Elastizität, die Biegesteifigkeit, die Torsionssteifigkeit und/oder die Masse desselben. Hinsichtlich der Beschreibung dieser Eigenschaften wird ergänzend auf die Darlegung des erfindungsgemäßen Verfahrens verwiesen.

Nach einer weiteren bevorzugten Ausführungsform umfasst die erfindungsgemäße Vorrichtung ferner eine Speichereinheit zur Speicherung des erfassten mindestens einen physikalischen Parameters und/oder eine Sendereinheit zur drahtlosen Weiterleitung derselben. Die Speichereinheit kann dabei bevorzugt in einem Hohlraum des Basiskörpers untergebracht oder diesem auf andere Art zugeordnet sein. Alternativ oder zusätzlich kann vorgesehen sein, dass die mit dem mindestens einen Sensor erfassten Daten teilweise oder vollständig drahtlos zu einer Empfangseinrichtung weitergeleitet werden. Hinsichtlich weiterer Erläuterungen zur Speicherung bzw. Sendung wird ergänzend auf die obigen Darlegungen zum erfindungsgemäßen Verfahren verwiesen.

Um die erfassten Daten wie insbesondere die erfassten Kräfte auswerten zu können, kann die erfindungsgemäße Vorrichtung ferner eine Auswerteeinrichtung zur Weiterverarbeitung der erfassten mindestens einen physikalischen Parameters wie insbesondere der mechanischen Kräfte umfassen. Diese Auswerteeinrichtung kann bevorzugt außerhalb des Probekörpers angeordnet und diesem bzw. der erfindungsgemäßen Vorrichtung dementsprechend lediglich zugeordnet sein. Ebenfalls ist es bevorzugt, dass eine Anzeigeeinrichtung, beispielsweise in Form eines Bildschirms, vorgesehen ist, die eine Anzeige der erfassten Daten erlaubt.

Es ist außerdem bevorzugt, dass die erfindungsgemäße Vorrichtung ferner eine Ausgabeeinrichtung zur Ausgabe von optischen, akustischen und/oder elektrischen Signalen zur Statusanzeige umfasst. Derartige Signale können beispielsweise Warnsignale sein, die beim Überschreiten von zuvor direkt am Probekörper eingestellten Grenz- bzw. Normwerten ausgegeben werden, so dass ein Anwender unmittelbar und ohne die Notwendigkeit einer zusätzlichen, möglicherweise extern an- bzw. zugeordneten Anzeigeeinrichtung entsprechende Informationen erhält. Diese Signale können akustischer, optischer und/oder elektrischer Art sein, wobei die elektrischen Signale vornehmlich zur Erfassung durch entsprechende Empfänger geeignet sind, die an der Anlage angeordnet oder von dieser umfasst werden. So kann die Anlage beispielsweise so ausgestaltet sein, dass sie bei Empfang des entsprechenden Signals selbsttätig vom Fertigungsbetrieb in einen für den Messbetrieb geeigneten Modus umschaltet. Auch ein gezieltes Aussortieren eines im laufenden Betrieb in die Anlage eingebrachten Probekörpers kann so einfach realisiert werden.

Schließlich ist es bevorzugt, dass die erfindungsgemäße Vorrichtung ferner eine Energieversorgung umfasst. Diese Energieversorgung kann ausschließlich am oder im Probekörper angeordnet sein (beispielsweise Batterien, Kondensatoren), oder sie kann zusätzlich externe Komponenten umfassen (z.B. induktive Energieübertragung mittels Spulen). Besonders bevorzugt ist die Energieversorgung auflad- und/oder auswechselbar.

Bevorzugt ist der Probekörper rechteckig ausgestaltet. Nach einer besonders bevorzugten Ausführungsform ist der Probekörper quadratisch ausgestaltet.

Zur Erfassung des mindestens einen physikalischen Parameters stellt der allgemeine Stand der Technik eine Vielzahl unterschiedlichster Sensortypen bereit. Ein mögliches Auswahlkriterium ist dabei die Art, wie der physikalische Parameter von dem Sensor in ein Messsignal überführt wird. Nach einer bevorzugten Ausführungsform ist der mindestens eine Sensor derart ausgestaltet, dass er durch den auf den Probekörper einwirkenden mindestens einen Parameter eine Formänderung erfährt, aufgrund derer der Sensor den mindestens einen Parameter erfasst.

Nach einer einfachen Ausführungsform kann der Sensor als plastisch verformbare Schicht ausgestaltet sein oder eine solche umfassen. Eine derartige Schicht spiegelt die auf sie einwirkenden mechanischen Belastungen in Form von dauerhaften Verformungen wider, wobei die Stärke der Verformung in etwa der Höhe der mechanischen Belastung entspricht. Besonders bevorzugt sind dabei solche Materialien, die sich nach einer Messung, beispielsweise durch vorübergehende Erhöhung der Temperatur, wieder in ihren Ursprungszustand versetzen lassen.

Insbesondere sind solche Sensortypen bevorzugt, die bei gegebener Formänderung elektrische Signale erzeugen und/oder ihre elektrischen Eigenschaften ändern können. Nach einer besonders bevorzugten Ausführungsform wird das elektrische Signal aktiv vom Sensor erzeugt. Alternativ kann die Erfassung des Parameters durch den Sensor passiv erfolgen, wie es beispielsweise bei einer durch Formänderung induzierten Veränderung der elektrischen Eigenschaften der Fall ist, die nur in Verbindung mit einer extern angelegten Spannungs- und/oder Stromversorgung messbar ist. Schließlich sind alle diejenigen Sensortypen bevorzugt, die sich durch eine im Wesentlichen flächige Ausgestaltung auszeichnen.

Besonders bevorzugt sind außerdem solche Sensortypen, bei denen das Messsignal und/oder die Veränderung der elektrischen Eigenschaften in etwa proportional zur Formänderung des Sensors sind.

Nach einer bevorzugten Ausführungsform umfasst der mindestens eine Sensor mindestens eine piezoelektrische Kunststofffolie oder er ist als eine solche ausgebildet. Derartige Folien bestehen beispielsweise aus Polyvinylidenfluorid (PVDF), oder beinhalten zumindest eine Schicht aus einem derartigen Material, welches die Eigenschaft hat, auf eine mechanische Verformung mit einer Ladungsverschiebung zu reagieren.

Alternativ oder zusätzlich umfasst der mindestens eine Sensor mindestens einen Dehnungsmessstreifen (DMS) oder er ist als ein solcher ausgebildet. Weitere derartige Sensortypen sind beispielsweise als Leiterbahnen ausgebildet, die auch aus anderen Materialien als DMS gefertigt werden. Diese Leiterbahnen können auf flexible Folien aufgedruckt werden, wo sie ebenfalls auf Verformungen mit Widerstandsänderungen reagieren, oder zumindest eine mechanische Überbelastung mit einem Leitungsbruch anzeigen.

Derartige Sensoren können in sehr flacher Bauweise bereitgestellt werden, sind sehr robust und decken je nach Bauart einen sehr weiten Messbereich ab. Zudem lassen sich mit derartigen Sensoren auch hochgenaue Messungen von Kräften, Drücken und Momenten durchführen. Zudem erfüllen derartige Sensoren die Anforderung nach einer der Formänderung in etwa proportionalen Änderung des Messsignals.

Besonders bevorzugt sind Sensoren auf der Basis flacher piezoelektrischer Kunststofffolien, die auf jede Belastungsänderung mit einer entsprechenden Formänderung reagieren, wodurch aufgrund der internen Ladungsverschiebungen eine messbare Spannung erzeugt wird, so dass zum Betrieb des Sensors im Idealfall keine Betriebsenergie zur Erzeugung des elektrischen Messsignals benötigt wird. Es ist daher auch ausführbar, dass die von einem derartigen Sensor erzeugte Spannung außerdem noch zur Versorgung weiterer Komponenten wie z.B. der optional vorgesehenen Speicher- oder Sendereinheit dient.

Nach einer besonders bevorzugten Ausführungsform ist der mindestens eine Sensor parallel oder diagonal zu den Kanten des Probekörpers angeordnet. Im Falle mehrerer derartiger Sensoren ist es am meisten bevorzugt, dass diese parallel und diagonal zu den Kanten angeordnet sind. Es ist ferner bevorzugt, dass der mindestens eine Sensor rechteckig ausgebildet und so angeordnet ist, dass die zu erfassende mechanische Belastung gleichzeitig auf eine möglichst große Fläche des Sensors einwirkt, um ein entsprechend großes Messsignal zu erhalten. Im Falle einer Rollentransporteinrichtung mit quer zur Transportrichtung liegenden Rollen ist demnach eine Anordnung des bzw. der Sensoren parallel zur Rollenachse zu bevorzugen, da dann die Belastung gleichzeitig auf eine möglichst große Fläche eines jedes rechteckigen Sensors wirkt, woraus jeweils ein entsprechend großes Messsignal resultiert.

Nach einer anderen Ausführungsform ist es vorgesehen, dass die erfindungsgemäße Vorrichtung mindestens zwei Sensoren umfasst, die auf der Ober- und Unterseite des Probekörpers angeordnet sind.

Nach einer weiteren bevorzugten Ausführungsform umfasst die Vorrichtung mindestens einen Sensor, der an einer oder mehreren Kanten des Probekörpers angeordnet ist.

Ferner ist bevorzugt, dass die mindestens einen Sensor umfassende Vorrichtung eine hohe Abtastrate bzw. Messfrequenz ermöglicht, um auch kurze, impulsartige Stöße, die beispielsweise an den Kanten des Probekörpers auftreten können, zu erfassen. Dazu muss die Messfrequenz mindestens 5 Hz betragen. Bevorzugt liegt die Messfrequenz in einem Bereich von 20 Hz bis 1 kHz oder höher, wobei Messfrequenzen oberhalb von 1 kHz besonders bevorzugt sind.

Nach einer besonders bevorzugten Ausführungsform der erfindungsgemäßen Vorrichtung ist an der Oberfläche des Basiskörpers eine elastische Zwischenschicht angeordnet, welcher der mindestens eine Sensor funktionell und somit zumindest teilweise aufgelagert ist. Der Begriff "elastisch" dient hier im Wesentlichen der Abgrenzung zu "plastisch". Das bedeutet, dass die Zwischenschicht nach einer mechanischen Belastung wieder ihre Ruheposition einnimmt. Eine plastische (bleibende) Verformung ist hingegen nicht vorgesehen. Durch diese Zwischenschicht kann der mindestens eine Sensor in gewissem Umfang vom Basiskörper mechanisch entkoppelt werden und/oder eine Verformungsverstärkung erfahren, wobei letztere Eigenschaft eine Verstärkung des Messsignals ermöglicht. Diese Verstärkung beruht im beispielhaften Falle eines eine piezoelektrische Kunststofffolie umfassenden Sensors auf der Verlängerung des Verformungsweges, den die piezoelektrische Kunststofffolie bei einer mechanischen Belastung zurücklegen kann. Ohne die elastische Zwischenschicht ist der Verformungsweg aufgrund der relativ geringen Verformbarkeit der Kunststofffolie selber begrenzt, da diese direkt auf dem gewöhnlich sehr steifen Basiskörper aufgelegt ist. Zusammen mit der elastischen Zwischenschicht kann sich die Kunststofffolie stärker verformen, da dies durch die geringe Steifigkeit bzw. hohe Elastizität und/oder Kompressibilität der elastischen Zwischenschicht erlaubt wird.

Für den Fall, dass die Zwischenschicht nicht selbsttätig an ihrer Position verbleibt, ist es vorteilhaft, wenn der mindestens eine Sensor derart angeordnet ist, dass durch ihn die Zwischenschicht fixiert wird. Dies kann beispielsweise dadurch geschehen, dass der Sensor seitlich über die Zwischenschicht herausragt und an seinen freien Kanten mit dem Basiskörper verbunden, beispielsweise verklebt ist. Alternativ oder zusätzlich kann es auch vorgesehen sein, dass die Zwischenschicht einen oder mehrere Durchgänge aufweist, die beispielsweise mit Klebstoff aufgefüllt sind, so dass Sensor und Zwischenschicht am Basiskörper fixiert werden.

Wie bereits erwähnt, kann der mindestens eine Sensor, gegebenenfalls auch zusammen mit der Zwischenschicht, dem Basiskörper beispielsweise aufgelagert oder in diesen voll- oder teilintegriert sein, so dass gewünschtenfalls eine glatte Außenfläche des Basiskörpers entsteht.

Die elastische Zwischenschicht kann im Rahmen der Erfindung mehrere Aufgaben erfüllen, wobei es besonders bevorzugt ist, dass mehrere der im Folgenden detailliert beschriebenen Aufgaben parallel erfüllt werden.

Eine erste Aufgabe der Zwischenschicht besteht darin, einen vergrößerten Verformungsweg des mindestens einen erfindungsgemäßen Sensors zu ermöglichen. Dazu kann es erfindungsgemäß vorgesehen sein, dass die elastische Zwischenschicht eine Steifigkeit und/oder Kompressibilität aufweist, die jeweils geringer ist als diejenige des Basiskörpers und des mindestens einen Sensors.

Nach einer alternativen Ausführungsform kann der vergrößerte Verformungsweg auch dadurch bereitgestellt werden, dass die Zwischenschicht Vertiefungen und/oder Hohlräume aufweist, in die sich der Sensor hineinverformen kann, ohne dass ihm auf diesem Weg ein wesentlicher Widerstand entgegengesetzt wird, da bei der Verformung in die Vertiefungen und/oder Hohlräume hinein kein festes Material verdrängt oder komprimiert werden muss. Daher kann nach dieser Ausführungsform die Zwischenschicht auch aus einem im Wesentlichen unelastischen oder festen Material bestehen, sofern sie eine genügend große Anzahl besagter Vertiefungen und/oder Hohlräume aufweist. Erfindungsgemäß kann die Zwischenschicht demnach aus einer Vielzahl verformbarer Materialien beschaffen sein sowie eine homogene oder heterogene Struktur aufweisen, wobei eine heterogene Struktur das Vorhandensein verformbarer und nicht verformbarer Bestandteile bezeichnet. Durch konkrete Ausgestaltung der elastischen Schicht kann somit erreicht werden, dass die Empfindlichkeit des mindestens einen Sensors in weiten Bereichen an die jeweilige Aufgabenstellung angepasst werden kann.

Eine zweite Aufgabe der Zwischenschicht besteht in einer mechanischen Entkopplung des Basiskörpers von den Belastungen des Sensors. Da die Zwischenschicht die Belastung teilweise absorbiert und sich dabei zusammen mit dem verformbaren Sensor wie z.B. der piezoelektrischen Kunststofffolie oder dem Dehnungsmessstreifen elastisch verformt, wird diese Belastung - je nach Steifigkeit - nur zu einem gewissen Teil an den Basiskörper weitergegeben, wodurch dieser wie insbesondere auch die in ihm integrierten elektronischen Bauelemente vor zu großen Belastungen geschützt werden können.

Eine dritte Aufgabe betrifft die Möglichkeit, die aus der Beschaffenheit des Basiskörpers und/oder des mindestens einen Sensors resultierende Steifigkeit des Probekörpers durch Bereitstellung einer in gewünschter Weise elastischen Zwischenschicht auf einen geeigneten Wert einzustellen. Auf diese Weise kann erreicht werden, dass trotz eines gegebenen Basiskörpers, der eine von den flachen Gegenständen abweichende Steifigkeit aufweist, in Kombination mit einer darauf abgestimmten Zwischenschicht eine Steifigkeit des Probekörpers erzielbar ist, die beispielsweise der Steifigkeit der flachen Gegenstände weitgehend entspricht.

Eine vierte Aufgabe der elastischen Zwischenschicht besteht schließlich darin, den Signal-Rauschabstand des mindestens einen Sensors zu verbessern, indem systembedingte oder andere nicht mit dem zu erfassenden Parameter zusammenhängende mechanische Belastungen von der Signalentstehung möglichst weitgehend ausgeschlossen werden. Im Falle des Vorhandenseins eines verformbaren Sensortyps kann auf diese Weise auch das thermische Rauschen reduziert werden, da sich eine ggf. auftretende Temperaturänderung des Basiskörpers weniger stark auf den Sensor auswirkt. Die Gegenwart einer elastischen Zwischenschicht wirkt sich also vorteilhaft auf den Signal-Rauschabstand des Sensors aus.

In Abhängigkeit der gestellten Aufgabe oder des konkreten Anwendungsgebietes kann die erfindungsgemäße Zwischenschicht auf verschiedene Weise realisiert werden. Nach einer ersten Ausführungsform ist die Zwischenschicht als homogene, beispielsweise gummiartige Schicht ausgebildet. Derartige Schichten sind biegsam, aber nur in geringem Umfang kompressibel. Sie eignen sich daher insbesondere zur Dämpfung und/oder Verteilung punktartiger Belastungen. Nach einer weiteren Ausführungsform kann die Zwischenschicht als schaumstoffartige Schicht ausgebildet sein, also offene und/oder geschlossene Hohlräume (Poren) aufweisen, die mit einen Gas wie insbesondere mit Luft gefüllt sind. Derartige Schaumstoffe haben den Vorteil, dass sie eine Poisson-Zahl (Querkontraktionszahl) nahe Null aufweisen, was gleichbedeutend mit der Eigenschaft ist, bei einachsiger Formänderung (z.B. Kompression) keine wesentlichen Formänderungen in die übrigen Achsenrichtungen zu zeigen. Eine Schicht aus einem derartigen Material ist demnach gut kompressibel, so dass insbesondere der Verformungsweg des Sensors bei Belastung verlängert wird. Es kann aber auch vorteilhaft sein, die elastische Zwischenschicht als hermetisch abgeschlossenes Gasvolumen ("Gasfeder") vorzusehen, welches den verformbaren Sensor im unbelasteten Zustand vom Basiskörper beabstandet hält, so dass im Belastungsfall eine entsprechende Verformung ohne wesentliche Zunahme der Belastung möglich ist. Nach einer anderen Ausführungsform ist die elastische Zwischenschicht als geometrisch modelliertes Gebilde ausgestaltet. So kann die elastische Zwischenschicht beispielsweise ein- oder beidseitig ein zwei- oder dreidimensionales Wellenmuster zeigen, eine waben- oder netzartige Struktur aufweisen, oder als Stützstruktur ausgebildet sein. Dazu kann sie beispielsweise als Lochfolie ausgestaltet sein. Je nach gewünschtem Verhalten des Schichtaufbaus kann es vorteilhaft sein, einen vorwiegend festes Material umfassenden Aufbau mit kleineren Aussparungen, oder einen vorwiegend größere Aussparungen umfassenden Aufbau mit nur geringem Materialanteil vorzusehen. Die wesentliche Eigenschaft einer derartig ausgestalteten elastischen Zwischenschicht liegt darin, dem Sensor bei einer gegebenen mechanischen Belastung einen zusätzlichen Verformungsweg zur Verfügung zu stellen. Wie bereits weiter oben erwähnt, ist es auch möglich, die elastische Zwischenschicht aus im Wesentlichen steifen Stützstrukturen aufzubauen, wie beispielsweise aus einem Metallnetz, welches entsprechend viele bzw. große Aussparungen aufweist. Es ist ferner möglich, die oben genannten Aussparungen teilweise oder vollständig mit einem Füllmaterial zu versehen. Für den Fall, dass das Füllmaterial eine geringere Steifigkeit als das umgebende Material aufweist, wird die Steifigkeit der Zwischenschicht geringfügig erhöht. Es ist jedoch auch der umgekehrte Fall denkbar, in dem das umgebende Material eine geringere Steifigkeit als das Füllmaterial aufweist, beispielsweise wenn eine Lochfolie aus Silikon mit Epoxydharz verfüllt wird.

Schließlich kann es vorteilhaft sein, mehrere Bereiche unterschiedlicher Zwischenschichten unter einem Sensor vorzusehen. Dies kann beispielsweise dann sinnvoll sein, wenn ein großflächiger Sensor sowohl Bereiche hoher Belastung, als auch solche mit hoher Empfindlichkeit aufweisen soll.

Nach einer besonders bevorzugten Ausführungsform ist die elastische Zwischenschicht als netzartige Silikonfolie ausgebildet. Zum kraftschlüssigen Fügen der Zwischenschicht mit dem Basiskörper einerseits und der Kunststofffolie andererseits kann bevorzugt ein entsprechend geeigneter Klebstoff verwendet werden, der besonders bevorzugt die gleichen mechanischen Eigenschaften wie die Silikonfolie aufweist. Ebenfalls besonders bevorzugt ist es, den Einschluss von Gasblasen entweder ganz auszuschließen, oder Gasblasen nur in einem regelmäßigen Muster zuzulassen, so dass die Eigenschaften der elastischen Zwischenschicht homogen bleiben. Erfindungsgemäß geeignete Zwischenschichten betreffen daher sowohl homogene als auch heterogene Strukturen, die gleiche oder unterschiedliche elastische Materialien umfassen können.

Nach einer anderen Ausführungsform ist es vorgesehen, mehrere erfindungsgemäße Sensoren vorzugsweise unterschiedlicher Größe übereinander anzuordnen, wobei es besonders bevorzugt ist, einen ersten Sensor zur Aufnahme beispielsweise eines auf den gesamten Probekörper wirkenden Druckes direkt auf dem Basiskörper anzuordnen, wobei die Oberfläche des Sensors derjenigen des Probekörpers vorzugsweise weitgehend entspricht. Auf diesen ersten Sensor können mit dann einer oder mehrere, vorzugsweise kleinere "lokal" messende Sensoren angeordnet werden, mit denen beispielsweise punktuell wirkende Kräfte ortsaufgelöst erfasst werden können.

Auch kann eine einzige elastische Zwischenschicht gleichzeitig für mehrere verformbare Sensoren wie z.B. piezoelektrische Kunststofffolien ausreichen, wenn diese beispielsweise streifenartig und parallel zueinander auf der gemeinsamen elastischen Zwischenschicht angeordnet sind.

Es ist außerdem vorteilhaft, den erfindungsgemäßen mindestens einen Sensor lösbar auf dem Probe- oder Basiskörper auszugestalten, was z.B. mittels Kleb-, Schraub- oder Klemmverbindungen realisiert werden kann. Auf diese Weise kann die Anordnung des mindestens einen Sensors in Bezug zum Probe- oder Basiskörper verändert werden. Auch ein Austausch gegen einen Sensor anderer Empfindlichkeit oder wegen eines Defektes kann auf diese Weise schnell und kostengünstig erledigt werden. Ferner weist der Probe- oder Basiskörper besonders bevorzugt eine Vielzahl elektrischer Anschlüsse auf, die so ausgestaltet sind, dass ein ggf. lösbar ausgestalteter Sensor diese ihm zugeordneten Anschlüsse bedecken kann, so dass das Messsignal über diese Anschlüsse abführbar ist, ohne zusätzliche Kabel oder dergleichen vorsehen zu müssen.

Nach einer weiteren bevorzugten Ausführungsform ist der Probekörper als Schichtaufbau ausgebildet, der chemisch resistente Außenschichten sowie eine Innenschicht umfasst, welche den mindestens einen Sensor sowie gewünschtenfalls weitere elektronische Komponenten aufweist.

Wie bereits ausgeführt, haben die jeweiligen Steifigkeiten der beteiligten Komponenten wesentlichen Einfluss auf das Verhalten eines Sensors mit elastischer Zwischenschicht. In vielen Fällen ist es bevorzugt, dass die Zwischenschicht eine Steifigkeit und/oder Kompressibilität aufweist, die jeweils geringer ist als diejenige des Basiskörpers und des mindestens einen Sensors, wobei je nach Aufgabenstellung auch Abweichungen von diesem Grundsatz möglich und sinnvoll sind. Besonders bevorzugt ist die Steifigkeit des Basiskörpers um einen Faktor zwischen 100 und 1.000, vorzugsweise um einen Faktor 250 höher als die Steifigkeit der Zwischenschicht. Alternativ oder zusätzlich weist die Steifigkeit des Basiskörpers einen Wert zwischen 100 und 3.000.000 MPa (N/mm²), vorzugsweise in etwa 500 MPa (N/mm²) auf, und/oder die Steifigkeit der Zwischenschicht weist einen Wert zwischen 1 und 30 MPa (N/mm²) vorzugsweise in etwa 2 MPa (N/mm²) auf.

Für den Fachmann ergibt sich aus der vorliegenden Beschreibung, dass die erfindungsgemäßen Verfahren und Vorrichtungen sehr gut für die Erfassung von Belastungen geeignet sind, die im Rahmen einer Behandlung auf bruchempfindliche flache Gegenstände wirken. Insbesondere sind die Verfahren und Vorrichtungen für eine kontinuierliche Erfassung der Belastungen an jedweder Stelle und/oder zu jedwedem Zeitpunkt einer Behandlung geeignet, ohne dass dafür eine Vielzahl von Sensoren benötigt wird. Die Erfindung ermöglicht vielmehr die Verwendung lediglich eines einzigen Sensors für jeden zu erfassenden Parameter, der insbesondere eine mechanische Belastung definiert. Durch die Nutzung hoher Abtastraten lassen sich auch kurzzeitige Belastungen wie insbesondere Stöße erfassen, die auf den erfindungsgemäßen Probekörper wirken. Durch Anwendung der erfindungsgemäßen Lehre können die Zeit und der Aufwand bei der Fehlersuche nach einer Überbelastung genauso minimiert werden wie bei einer Erstjustierung einer neu aufgebauten oder modifizierten Anlage. Darüber hinaus ist die Erfindung dazu geeignet, den Einfluss der Anwender auf das Ergebnis der Erfassung zu minimieren. Fertigungsausfälle und Stillstandszeiten können ebenfalls auf ein Minimum reduziert werden. Schließlich kann die Erfindung auch dazu eingesetzt werden, übertriebenen Aufwand bei der Vermeidung von Überbelastungen weitgehend auszuschließen. Ebenfalls können Belastungen, die sich aus mehreren Einzelbelastungen zusammensetzen, zuverlässig und getrennt voneinander in reproduzierbarer Weise erfasst werden. Auch kann die Erfindung dazu dienen, auf besonders effektive Art und Weise Aufschluss darüber zu geben, ob plötzlich auftretende Beschädigungen bei der Behandlung flacher Gegenstände durch einen Anlagenfehler oder Materialfehler der Gegenstände hervorgerufen wurden. Durch Verwendung einer erfindungsgemäßen Vorrichtung mit elastischer Zwischenschicht kann insbesondere die Empfindlichkeit eines bevorzugt als piezoelektrische Kunststofffolie ausgebildeten Sensors signifikant gesteigert werden, sofern die elastische Zwischenschicht durch ihre Formgebung und/oder ihre im Verhältnis zum Sensor und dem Basiskörper geringere Steifigkeit bzw. höhere Kompressibilität eine stärkere Verformung des Sensors ermöglicht, als es ohne die Zwischenschicht der Fall wäre. Die Zwischenschicht kann ferner eine Schutzfunktion gegenüber dem Basiskörper und/oder den in ihm enthaltenen Bauteilen erfüllen, eine Einstellung der Steifigkeit des Probekörpers ermöglichen, und den Signal-Rauschabstand positiv beeinflussen.

### Figurenbeschreibung

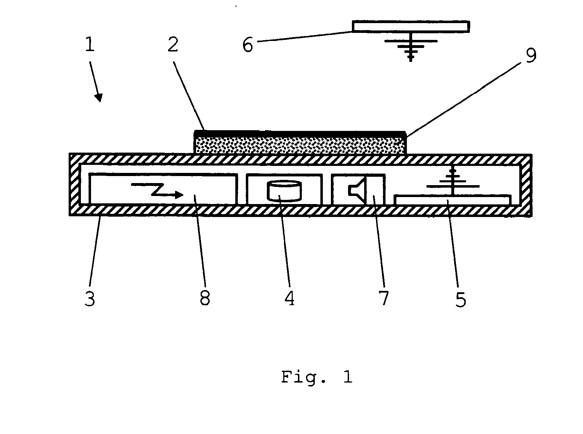

**Figur 1** zeigt eine bevorzugte Ausführungsform der erfindungsgemäßen Vorrichtung. Die dargestellte Vorrichtung besteht aus einem Probekörper 1, der einen Basiskörper 3 und einen Sensor 2 umfasst. Der Basiskörper 3 ist als Hohlkörper ausgebildet. Auf seiner Oberseite aufgelagert ist der Sensor 2, der nach der dargestellten Ausführungsform beispielsweise eine piezoelektrische Kunststofffolie sein kann, welche durch die durchgezogene dicke Linie gekennzeichnet ist. Mit Hilfe des Sensors 2 werden die interessierenden physikalischen Parameter wie beispielsweise mechanische Kräfte erfasst. Zwischen Sensor 2 und Basiskörper 3 ist eine Zwischenschicht 9 angeordnet. Diese absorbiert zumindest Teile der mechanischen und/oder thermischen Belastungen, die im Rahmen einer üblichen Behandlung auf den Probekörper 1 und somit auf den Sensor 2 wirken. Ferner erlaubt die Zwischenschicht eine Verlängerung des Verformungsweges bei einer mechanischen Belastung. Dazu weist die Zwischenschicht 9 vorzugsweise eine im Vergleich zum Sensor 2 und zum Basiskörper 3 geringere Steifigkeit auf. Verformungen oder Verschiebungen des Sensors 2 werden also sowohl nur gedämpft auf den Basiskörper 3 übertragen, fallen aber aufgrund des verlängerten Verformungsweges entsprechend stärker aus. Nach der dargestellten Ausführungsform ist die Zwischenschicht 9 vollständig auf dem Basiskörper 3 angeordnet. Nach einer nicht dargestellten alternativen Ausführungsform können die Zwischenschicht 9 und ggf. auch der Sensor 2 jedoch teilweise oder ganz in der Wandung des Basiskörpers 3 versenkt angeordnet sein, um eine möglichst glatte Außenkontur des Basisköpers 3 und somit des Probekörpers 1 zu erreichen (teilintegrierte bzw. vollintegrierte Anordnung). Es ist klar, dass in diesem Falle die Wandung eine entsprechende Mindestdicke aufweisen muss, die bevorzugt etwas größer als die Dicke der Zwischenschicht 9 ist, oder dass die Wandung eine entsprechende Vertiefung für die Zwischenschicht 9 und ggf. für den Sensor 2 bereitstellen muss (nicht dargestellt).

Innerhalb des Basiskörpers 3 sind weitere Komponenten angeordnet. Diese Komponenten betreffen eine Energieversorgung 8, eine Speichereinheit 4, welche der Speicherung der erfassten Parameter dient, sowie eine Sendereinheit 5, mit welcher die erfassten Parameter drahtlos zu einer Auswerteeinrichtung 6 gesendet werden können, die nach der dargestellten Ausführungsform außerhalb des Probekörpers 1 angeordnet ist. Schließlich umfasst der Basiskörper 3 auch eine Ausgabeeinrichtung 7, die nach der dargestellten Ausführungsform ein akustisches Signal erzeugen kann. Dieses kann beispielsweise einem Anwender bestimmte Zustände des Probekörpers 1 signalisieren, ohne dass hierzu eine weitere Anzeige erforderlich wäre.

Zum Betrieb der erfindungsgemäßen Vorrichtung notwendige elektrische Leitungen und dergleichen sind aus Gründen der Übersichtlichkeit nicht dargestellt. Auch ist die Figur nicht maßstäblich, was insbesondere das Verhältnis von Breite zu Dicke des Probekörpers 1 betrifft.

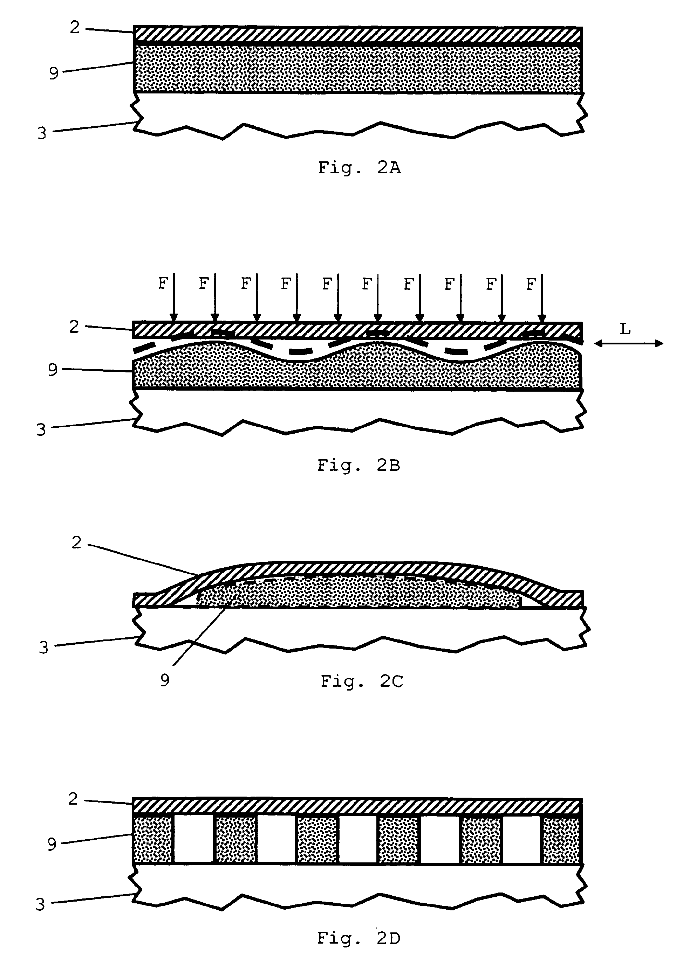

Die **Figuren 2A-D** zeigen die erfindungsgemäße Vorrichtung mit mehreren Ausführungsformen der elastischen Zwischenschicht 9 in einer schematischen Querschnittsansicht. Dargestellt sind ein Ausschnitt des Basiskörpers 3 (gebrochen dargestellt), die elastische Zwischenschicht 9 (Fläche punktiert), und der Sensor 2 (Fläche schraffiert), der als piezoelektrische Kunststofffolie ausgebildet ist.

In der **Figur 2A** ist die elastische Zwischenschicht 9 als homogene, gleichförmig dicke Schicht dargestellt, welcher der Sensor 2 aufgelagert ist. Die Zwischenschicht 9 ist auf einem als Ausschnitt dargestellten Teil des Basiskörpers 3 angeordnet. Die hier gezeigte Ausführungsform eignet sich insbesondere für eine oder mehrere punktuell wirkende und voneinander beabstandete Kräfte, da großflächig wirkende Kräfte lediglich eine gleichmäßige Kompression der Zwischenschicht 9 hervorrufen, ohne den Verformungsweg des Sensors 2 wesentlich zu verlängern.

Die **Figur 2B** zeigt die elastische Zwischenschicht 9 als geometrisch modelliertes Gebilde, welches im zweidimensionalen Schnitt eine einseitig-wellenförmige Kontur aufweist. Bei Belastung, angedeutet durch die Kraftpfeile F, verformt sich der Sensor 2 dergestalt, dass er sich in die wellenförmigen Aussparungen der elastischen Zwischenschicht 9 hinein verformt. Dabei wird er in Längsrichtung L gedehnt, und zwar deutlich stärker, als wenn die elastische Zwischenschicht 9 keine entsprechenden Aussparungen aufweisen würde. Die ungefähre Endlage des Sensors 2 wird durch die gestrichelte Linie angedeutet, wobei die elastische Zwischenschicht 9 hier eine relativ hohe Steifigkeit aufweist. Im Gegensatz zu der in der Figur 2A dargestellten Ausführungsform eignet sich die hier gezeigte Ausführungsform insbesondere auch für großflächig wirkende Kräfte oder für Drücke.

Die **Figur 2C** zeigt einen Aufbau, nach welchem die elastische Zwischenschicht als Gasfeder ausgebildet ist. Hierzu muss der Sensor umlaufend hermetisch mit dem Basiskörper 3 verschweißt sein, oder die elastische Zwischenschicht 9 muss in Form einer Gasblase vorliegen, wie es durch die gestrichelte Kontur derselben angedeutet ist.

In der **Figur 2D** schließlich ist die elastische Zwischenschicht 9 als gleichmäßig dicke Schicht mit Durchgangslöchern dargestellt. Durch Variation der Größe, Lage und Anzahl der Löcher kann besonders einfach sowohl vollflächig als auch teilflächig auf ihre Steifigkeit Einfluss genommen werden. Alternativ können auch Aussparungen vorgesehen sein, die sich in einer nicht dargestellten Draufsicht beispielsweise als Schlitze oder spiralförmige Konturen darstellen. Die Steifigkeit der elastischen Zwischenschicht 9 kann dabei wahlweise gering oder hoch sein. In jedem Fall ermöglicht es die Formgebung der elastischen Zwischenschicht 9 bzw. ihrer Aussparungen, dass der Sensor 2 genügend Möglichkeiten hat, sich bei Belastung (nicht dargestellt) in Richtung des Basiskörpers 3 zu verformen.

### Bezugszeichenliste und Abkürzungen

- 1: Probekörper
- 2: Sensor
- 3: Basiskörper
- 4: Speichereinheit
- 5: Sendereinheit
- 6: Auswerteeinrichtung
- 7: Ausgabeeinrichtung
- 8: Energieversorgung
- 9: Elastische Zwischenschicht
- F: Kraftpfeil
- L: Längsrichtung

## Patentansprüche

1. Verfahren zur Erfassung von Belastungen, die im Rahmen einer üblichen Behandlung flacher, scheibenartiger und bruchempfindlicher Gegenstände auf dieselben einwirken, durch Anwendung der Behandlung auf einen Probekörper (1), der mindestens einen eine piezoelektrische Kunststofffolie umfassenden oder als eine solche ausgebildeten Sensor (2) zur Erfassung mindestens eines während der Behandlung auf den Probekörper (1) einwirkenden und aus der Gruppe bestehend aus Zugkräften, Druckkräften, Scherkräften, Drücken, Biegemomenten, Torsionsmomenten, Beschleunigungen, und Kombinationen davon ausgewählten physikalischen Parameters umfasst, **dadurch gekennzeichnet, dass** der Probekörper (1) als Bestandteil einen Basiskörper (3) umfasst, der im Wesentlichen die geometrischen und/oder mechanischen Eigenschaften der Gegenstände aufweist und an dessen Oberfläche eine elastische Zwischenschicht (9) angeordet ist, welcher der mindestens eine Sensor (2) zumindest teilweise aufgelagert ist.

2. Verfahren nach Anspruch 1, wobei die geometrischen Eigenschaften des Basiskörpers (3) die Dicke, Bereite, Länge, und/oder die Kontur desselben betreffen, und wobei die mechanischen Eigenschaften des Basiskörpers (3) die Elastizität, die Biegesteifigkeit, die Torsionssteifigkeit, und/oder die Masse desselben betreffen.

3. Verfahren nach Anspruch 1 oder 2, wobei die Behandlung bei der Fertigung oder Herstellung von Solarzellen oder Solarwafern zur Anwendung kommt.

4. Vorrichtung zur Erfassung von Belastungen, die im Rahmen einer üblichen Behandlung flacher, scheibenartiger und bruchempfindlicher Gegenstände auf dieselben einwirken, umfassend einen Probekörper (1), der mindestens einen eine piezoelektrische Kunststofffolie umfassenden oder als eine solche ausgebildeten Sensor (2) zur Erfassung mindestens eines während der Behandlung auf den Probekörper (1) einwirkenden und aus der Gruppe bestehend aus Zugkräften, Druckkräften, Scherkräften, Drücken, Biegemomenten, Torsionsmomenten, Beschleunigungen, und Kombinationen davon ausgewählten physikalischen Parameters umfasst, **dadurch gekennzeichnet, dass** der Probekörper (1) als Bestandteil einen Basiskörper (3) umfasst, der im Wesentlichen die geometrischen und/oder mechanischen Eigenschaften der Gegenstände aufweist und an dessen Oberfläche eine elastische zwischenschicht (9) angeordnet ist, welcher der mindestens eine Sensor (2) zumindest teilweise aufgelagert ist.

5. Vorrichtung nach Anspruch 4, wobei die geometrischen Eigenschaften des Basiskörpers (3) die Dicke, Bereite, Länge, und/oder die Kontur desselben betreffen, und wobei die mechanischen Eigenschaften des Basiskörpers (3) die Elastizität, die Biegesteifigkeit, die Torsionssteifigkeit und/oder die Masse desselben betreffen.

6. Vorrichtung nach Anspruch 4 oder 5, ferner umfassend
- eine Speichereinheit (4) zur Speicherung des erfassten mindestens einen physikalischen Parameters und/oder eine Sendereinheit (5) zur drahtlosen Weiterleitung desselben;
- eine Auswerteeinrichtung (6) zur Weiterverarbeitung des erfassten mindestens einen physikalischen Parameters;
- eine Ausgabeeinrichtung (7) zur Ausgabe von optischen, akustischen und/oder elektrischen Signalen zur Statusanzeige;
- eine Energieversorgung (8).

7. Vorrichtung nach einem der Ansprüche 4 bis 6, wobei der Probekörper (1) als Schichtaufbau ausgebildet ist, wobei der Schichtaufbau chemisch resistente Außenschichten sowie eine Innenschicht umfasst, welche den mindestens einen Sensor (2) sowie gewünschtenfalls weitere elektronische Komponenten aufweist.

## Claims

1. A method of measuring loads acting on flat, disk-like and fragile objects during the course of their usual processing, by applying the processing to a test body (1) comprising at least one sensor (2) for measuring at least one physical parameter that acts on the test body (1) during the course of its processing and is selected from the group consisting of tensile forces, pressure forces, shear forces, pressures, bending moments, torsion moments, acceleration forces, and combinations thereof, wherein the at least one sensor (2) comprises or is designed as a piezoelectric plastic film, **characterized in that** the test body (1) comprises as a component a base body (3) that has basically the geometrical and/or mechanical properties of said objects and that has an elastic interlayer (9) arranged at its surface onto which the at least one sensor (2) is fitted at least partly.

2. The method according to claim 1, wherein the geometrical properties of the base body (3) relate to its thickness, width, length, and/or outline, and wherein the mechanical properties of the base body (3) relate to its elasticity, bending stiffness, torsional stiffness, and/or mass.

3. The method according to claim 1 or 2, wherein the processing is used in the manufacturing or production of solar cells or solar wafers.

4. A device for measuring loads acting on flat, disk-like and fragile objects during the course of their usual processing, comprising a test body (1) comprising at least one sensor (2) for measuring at least one physical parameter that acts on the test body (1) during the course of its processing and is selected from the group consisting of tensile forces, pressure forces, shear forces, pressures, bending moments, torsion moments, acceleration forces, and combinations thereof, wherein the at least one sensor (2) comprises or is designed as a piezoelectric plastic film, **characterized in that** the test body (1) comprises as a component a base body (3) that has basically the geometrical and/or mechanical properties of said objects and that has an elastic interlayer (9) arranged at its surface onto which the at least one sensor (2) is fitted at least partly.

5. The device according to claim 4, wherein the geometrical properties of the base body (3) relate to its thickness, width, length, and/or outline, and wherein the mechanical properties of the base body (3) relate to its elasticity, bending stiffness, torsional stiffness, and/or mass.

6. The device according to claim 4 or 5, further comprising:
- a memory unit (4) for storing the measured at least one physical parameter and/or a transmitter unit (5) for wireless transmission of the same;
- an evaluator unit (6) for the further processing of the measured at least one physical parameter;
- an output unit (7) to output optical, acoustical and/or electrical signals for monitoring the status;
- an energy supply unit (8).

7. The device according to one of claims 4 to 6, wherein the test body (1) is designed as a layered structure, wherein the layered structure comprises chemically resistant outer layers as well as an inner layer having the at least one sensor (2) and, if desired, further electronic components.

## Revendications

1. Procédé pour la mesure des charges qui s'exercent sur des objets plats, en forme de disque et fragiles dans le cadre d'un traitement usuel, par l'application du traitement sur un spécimen (1) qui comprend au moins un capteur (2) pour mesurer au moins un des paramètres physiques agissant sur le spécimen (1) pendant le traitement et sélectionné dans le groupe constitué par les forces de tension, les forces de compression, les forces de cisaillement, les pressions, les moments de flexion, les moments de torsion, les accélérations et les combinaisons de paramètres physiques choisis parmi ceux-ci, lequel, au moins un, capteur (2) comprend ou est constitué par un film plastique piézoélectrique, **caractérisé en ce que** le spécimen (1) comprend comme élément un échantillon (3) qui présente pour l'essentiel les propriétés géométriques et/ou mécaniques des objets et une couche intermédiaire élastique (9) à sa surface laquelle est couverte au moins partiellement par le, au moins un, capteur (2).

2. Procédé selon la revendication 1, dans lequel les propriétés géométriques de l'échantillon (3) concernent son épaisseur, sa largeur, sa longueur, et/ou sa forme et les propriétés mécaniques de l'échantillon (3) concernent son élasticité, sa résistance à la flexion, sa résistance à la torsion, et/ou sa masse.

3. Procédé selon la revendication 1 ou la revendication 2, dans lequel le traitement est mis en application pour la fabrication ou production de cellules ou plaquettes photovoltaïques.

4. Dispositif pour la mesure des charges qui s'exercent sur des objets plats, en forme de disque et fragiles dans le cadre d'un traitement usuel, par l'application du traitement sur un spécimen (1) qui comprend au moins un capteur (2) pour mesurer au moins un des paramètres physiques agissant sur le spécimen (1) pendant le traitement et sélectionné dans le groupe constitué par les forces de tension, les forces de compression, les forces de cisaillement, les pressions, les moments de flexion, les moments de torsion, les accélérations et les combinaisons de paramètres physiques choisis parmi ceux-ci, lequel, au moins un, capteur (2) comprend ou est constitué par un film plastique piézoélectrique, **caractérisé en ce que** le spécimen (1) comprend comme élément un échantillon (3) qui présente pour l'essentiel les propriétés géométriques et/ou mécaniques des objets et une couche intermédiaire élastique (9) à sa surface laquelle est couverte au moins partiellement par le, au moins un, capteur (2).

5. Dispositif selon la revendication 4, dans lequel les propriétés géométriques de l'échantillon (3) concernent son épaisseur, sa largeur, sa longueur, et/ou sa forme et les propriétés mécaniques de l'échantillon (3) concernent son élasticité, sa résistance à la flexion, sa résistance à la torsion, et/ou sa masse.

6. Dispositif selon la revendication 4 ou la revendication 5 comprenant de plus
- une unité de mémorisation (4) pour sauvegarder les données obtenues pour le, au moins un, paramètre physique et/ou une unité de transmission (5) pour la transmission sans fil de celles-ci;
- un transducteur processeur (6) pour le traitement des données du, au moins un, paramètre physique;
- une unité de distribution (7) pour l'affichage de signaux optiques, acoustiques et/ou électriques du statut;
- une alimentation en énergie (8).

7. Dispositif selon une des revendications 4 à 6, dans lequel le spécimen (1) est conçu comme une structure en couche, la structure en couche comprenant des couches externes résistantent chimiquement et une couche interne qui contient le, au moins un, capteur (2) ainsi que si souhaité d'autres composants électroniques.
